Europäisches Patentamt

European Patent Office

Office européen des brevets

(11) Veröffentlichungsnummer: **0 283 906**
**A1**

(19)

(12) **EUROPÄISCHE PATENTANMELDUNG**

(21) Anmeldenummer: **88104111.5**

(22) Anmeldetag: **15.03.88**

(51) Int. Cl.⁴: **G11C 29/00**

Ein Antrag gemäss Regel 88 EPÜ auf Berichtigung der Beschreibung, Ansprüchen und Zeichnungen liegt vor. Über diesen Antrag wird im Laufe des Verfahrens vor der Prüfungsabteilung eine Entscheidung getroffen werden (Richtlinien für die Prüfung im EPA, A-V, 2.2).

(30) Priorität: **16.03.87 DE 3708488**

(43) Veröffentlichungstag der Anmeldung:
**28.09.88 Patentblatt 88/39**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Oberle, Hans-Dieter, Dipl.-Ing.**
**Edelweissstrasse 82**
**D-8039 Puchheim(DE)**
Erfinder: **Hoffmann, Kurt, Prof. Dr.**
**Neikenweg 20**
**D-8028 Taufkirchen(DE)**
Erfinder: **Kowarik, Oskar, Dr. rer. nat.**
**Goethering 70**
**D-8018 Grafing(DE)**
Erfinder: **Kraus, Rainer, Dipl.-Phys.**
**Weidener Strasse 21**
**D-8000 München 83(DE)**

(54) **Verfahren und Schaltungsanordnung zum Prüfen eines Halbleiterspeichers.**

(57) Bei dem erfindungsgemäßen Verfahren werden in korrespondierende Speicherzellen (SZ) zweier Blöcke (B1,B2) eines Halbleiterspeichers gleiche Daten eingeschrieben. Alle Speicherzellen (SZ) zweier korrespondierender Wortleitungen (WL) der Blöcke (B1,B2) werden gleichzeitig ausgelesen. Die Daten werden verstärkt und miteinander verglichen. Das Ergebnis wird einem Fehlersignal (F) zugeführt. Es wird eine Schaltung vorgestellt, die die Durchführung dieses Verfahrens ermöglicht. Die Erfindung ist auch bei Video-RAM's anwendbar.

FIG 1

EP 0 283 906 A1

### Verfahren und Schaltungsanordnung zum Prüfen eines Halbleiterspeichers

Die Erfindung betrifft ein Verfahren und eine Schaltungsanordnung zum Prüfen eines Halbleiterspeichers nach den Oberbegriffen der Patentansprüche 1 und 5.

Die Zunahme der Anzahl von Speicherzellen in einem Halbleiterspeicher hat in den letzten Jahren zu einem enormen Anstieg der zum Testen eines Halbleiterspeichers notwendigen Testzeit geführt. Während beispielsweise ein DRAM mit 4kB Speicherkapazität seinerzeit in drei bis zwanzig Sekunden Prüfzeit (abhängig von Art und Anzahl der verwendeten Prüfmuster und sonstiger Prüfbedingungen) ausreichend prüfbar war, bewegt sich die Prüfzeit eines modernen 1MB-DRAM's in der Größenordnung von 20 Minuten.

Aufgabe der vorliegenden Erfindung ist es, ein Verfahren und eine Schaltungsanordnung anzugeben, die es erlauben, einen Halbleiterspeicher funktionsmäßig in wesentlich kürzerer Zeit als bisher üblich zu prüfen. Dazu sollte nur ein minimaler zusätzlicher Flächenbedarf notwendig sein. Es wird jedoch bewußt in Kauf genommen, daß beim Prüfen unter Umständen nicht alle Fehler erkannt werden können. Es soll jedoch ein Großteil der möglichen Fehler erkennbar sein.

Es sind bereits verschiedene Maßnahmen zur Verkürzung der Prüfzeit bekannt: Die EP-A 0 186 040 - schlägt beispielsweise vor, einen Halbleiterspeicher intern in mehrere gleiche Blöcke einzuteilen und diese parallel zueinander zu testen. Damit läßt sich in der Praxis die Testzeit auf etwa 1/4 bis 1/8 reduzieren.

Die US-PS 4,055,754 schlägt vor, jeweils alle Speicherzellen einer kompletten Wortleitung zeitlich parallel zueinander zu testen und dazu eine bestimmte Auswerteschaltung innerhalb des Halbleiterspeichers zu benützen. Diese Lösung ist, trotz großer Testzeitersparnis, insofern nachteilig, als eine Auswerteschaltung notwendig ist, die aus wenigstens drei logischen Gattern besteht, wovon zwei dieser Gatter eine Anzahl von Eingängen benötigen, die gleich der Anzahl der vorhandenen Wortleitungen ist. Eine Realisierung führt zu einem sehr großen zusätzlichen Flächenbedarf, was dem allgemeinen Trend hin zum Miniaturisieren von Schaltungen zuwiderläuft.

Die gestellte Aufgabe wird gelöst durch die kennzeichnenden Merkmale der Patentansprüche 1 und 5. Vorteilhafte Aus-und Weiterbildungen sind in Unteransprüchen gekennzeichnet.

Die Erfindung wird anhand von Figuren näher erläutert.

Fig. 1 zeigt eine allgemeine Übersicht über einen Halbleiterspeicher nach der erfindungsgemäßen Schaltungsanordnung,

die Figuren 2 und 3 zeigen vorteilhafte Ausführungsformen der Erfindung, jeweils dargestellt in - schematisierter Form und beschränkt auf erfindungswesentliche Einzelheiten.

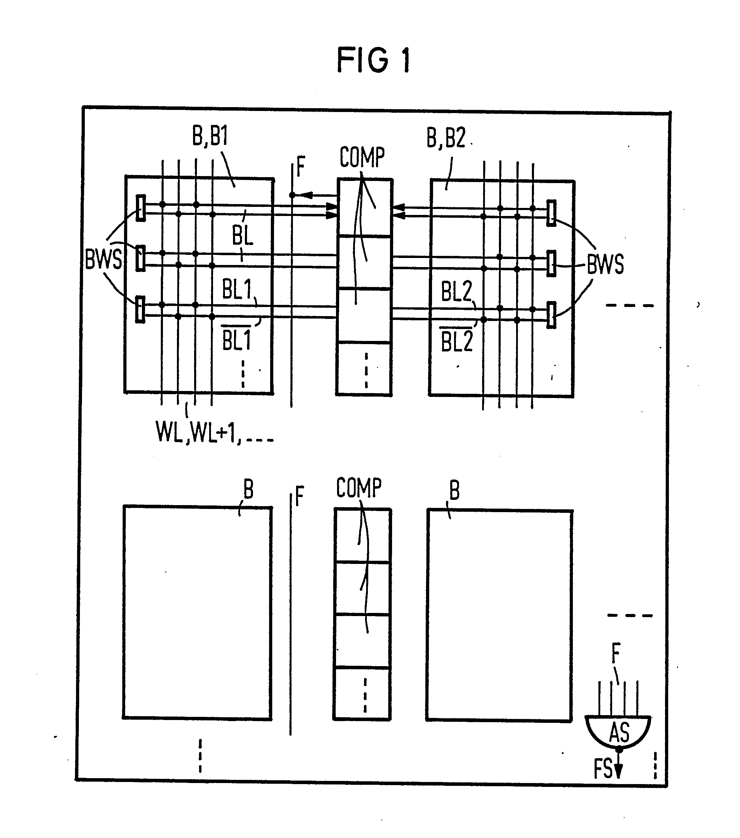

Ein Halbleiterspeicher enthält im allgemeinen, wie in Fig. 1 dargestellt, eine Anzahl von Blöcken B, auch Speicherzellenfelder genannt. Die Blöcke B sind untereinander alle gleich, sie enthalten die Speicherzellen SZ des Halbleiterspeichers in matrixförmiger Anordnung. Die Speicherzellen SZ sind mittlerweile meist nach dem sogenannten "folded-bitline"-Konzept organisiert. Bitleitungen bei Halbleiterspeichern sind grundsätzlich in zwei annähernd gleiche Hälften BLi, $\overline{BLi}$ aufgeteilt, die beide gemeinsam mit einer Bewerterschaltung BWS verbunden sind. Beim folded-bitline-Konzept sind die beiden Bitleitungshälften parallel nebeneinander geführt, wie in Fig. 1 dargestellt. Eine traditionelle Anordnung, auf die die vorliegende Erfindung zwar angewandt werden kann, die jedoch nicht dargestellt ist, da sie jedem Fachmann geläufig ist und da es dem Fachmann keine Schwierigkeiten bereitet, die anhand des folded-bitline-Konzepts dargestellte Erfindung auf diese andere Konzeption anzuwenden, stellt das sogenannte "open-bitline"-Konzept dar.

Jeder Bitleitung BL ist, unabhängig vom angewandten Bitleitungskonzept, eine Bewerterschaltung BWS zugeordnet, die beim Auslesen von Daten aus einer Speicherzelle das ausgelesene Datum bewertet und vorverstärkt. Beim folded-bitline-Konzept sind die Bewerterschaltungen seitlich am Zellenfeldrand bzw. Blockrand angeordnet; die Bitleitungshälften BLi, $\overline{BLi}$ liegen beide auf derselben Seite der Bewerterschaltung. Beim open-bitline-Konzept dagegen ist die Bewerterschaltung zwischen den beiden Bitleitungshälften BLi, $\overline{BLi}$ angeordnet. Sie liegen damit mittig im Zellenfeld bzw. Block B.

Ausgelesene bzw. einzuschreibende Daten werden über sogenannte externe Bitleitungen von den Bewerterschaltungen zu halbleiterspeicherinternen Peripherieschaltungen (bzw. umgekehrt) geführt. Dies ist allgemein bekannt; es ist der Einfachheit halber nicht dargestellt; auch ist es nicht Bestandteil der Erfindung.

Bei der vorliegenden Erfindung nach Fig. 1 weist der Halbleiterspeicher, wie oben bereits erwähnt, matrixförmig angeordnete Speicherzellen SZ auf. Sie sind in Blöcken B enthalten. Die Blöcke B, auch Speicherzellenfelder genannt, sind bezüglich der Speicherzellen SZ einander gleich ausgeführt. Sie sind in einer geradzahligen Anzahl vorhanden. Die Speicherzellen SZ sind innerhalb jedes Blockes B über Wortleitungen WL und Bitleitungen BL adressierbar. Die Bitleitungen BL sind in jedem Block jeweils in eine erste Bitleitungshälfte BLi und in eine zweite Bitleitungshälfte $\overline{BLi}$ eingeteilt. Beide Bitleitungshälften BLi, $\overline{BLi}$ einer Bitleitung BL sind mit einer Bewerterschaltung BWS verbunden. Die Funktion einer Bewerterschaltung BWS ist vorstehend bereits erläutert.

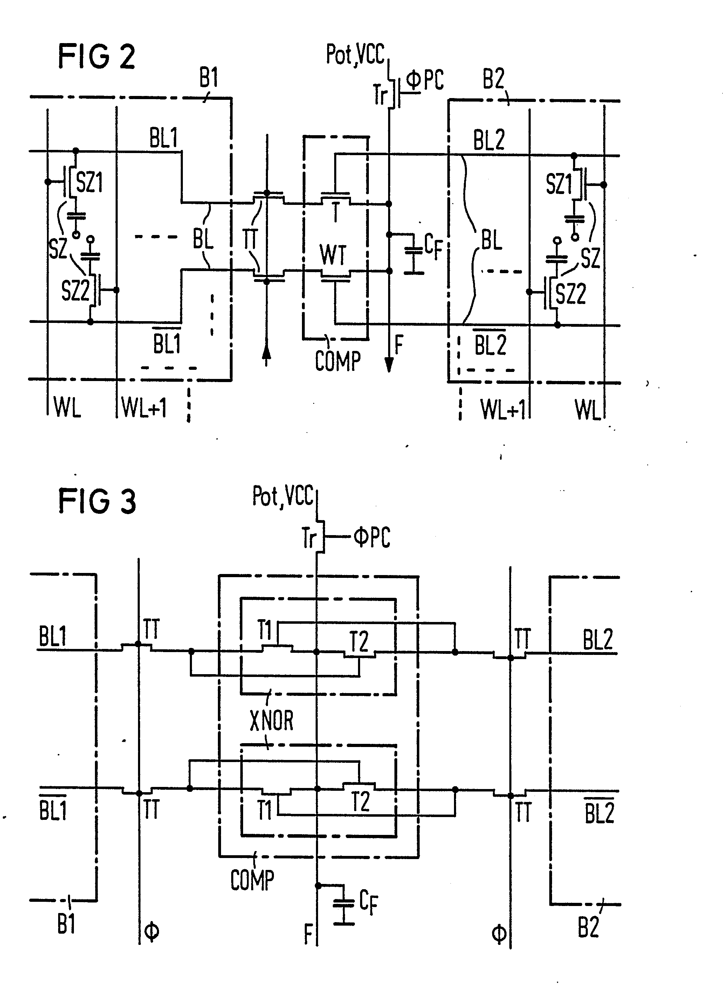

Die Blöcke B sind einander jeweils paarweise als erster Block B1 und als zweiter Block B2 zugeordnet. In Fig. 2 ist dies näher dargestellt. Die Zuordnung ist dergestalt, daß in jedem der beiden Blöcke B1,B2 unter jeder beliebigen blockinternen Adresse (Adresse = Kombination einer bestimmten, über Decoder anwählbaren Bitleitung BL und einer bestimmten, ebenfalls über einen Decoder anwählbaren Wortleitung WL zur Auswahl einer so definierten Speicherzelle; die Decoder befinden sich meist außerhalb der Blöcke B) jeweils eine Speicherzelle SZ1 adressierbar ist, wobei die beiden Speicherzellen SZ1 dieselbe blockinterne Adresse aufweisen. Ein solches Paar von Speicherzellen SZ1 sei "korrespondierende Speicherzellen SZ1" genannt. In Fig. 2 sind zwei solche Paare dargestellt. Sie sind mit SZ1 und SZ2 bezeichnet. Die Wortleitungen, die korrespondierenden Speicherzellen zugehörig sind, seien korrespondierende Wortleitungen genannt. Entsprechendes gilt für die zugehörigen Bitleitungen bzw. Bitleitungshälften. In Fig. 2 sind bezüglich der korrespondierenden Speicherzellen SZ1 die Wortleitungen WL als korrespondierende Wortleitungen bezeichnet; bezüglich der korrespondierenden Speicherzellen SZ2 sind es die Wortleitungen WL + 1. Hinsichtlich der korrespondierenden Bitleitungen sind es bezüglich der korrespondierenden Speicherzellen SZ1 die Bitleitungshälften BL1 und BL2 sowie bezüglich der korrespondierenden Speicherzellen SZ2 die Bitleitungshälften $\overline{BL1}$ und $\overline{BL2}$ .

Bei dem erfindungsgemäßen Verfahren wird in die Speicherzellen SZ von wenigstens zwei einander zugeordneten Blöcken B1,B2 ein beliebiges Prüfmuster in Form von Daten eingeschrieben. Es ist jedoch darauf zu achten, daß das in den ersten Block B1 einzuschreibende Prüfmuster gleich ist dem in den zugeordneten zweiten Block B2 einzuschreibenden Prüfmuster. Zwischen den beiden einander zugeordneten Blöcken B1,B2 ist erfindungsgemäß eine Fehlerleitung F angeordnet. Sie könnte, von der Funktion her betrachtet, lokal auch woanders angeordnet sein. Dies hätte jedoch nachteilige Auswirkungen auf die notwendigen Leitungsführungen bezüglich der Bitleitungen BL. Die Fehlerleitung F wird, sei es vor oder nach dem Einschreiben der Daten, jedenfalls vor Auslesen der Daten, auf einen ersten logischen Pegel Pot vorge laden. Der erste logische Pegel Pot kann vorteilhafterweise das Versorgungspotential VCC des Halbleiterspeichers selbst sein. Das Vorladen selbst kann beispielsweise mittels eines Schalttransistors TR erfolgen, der über ein Precharge-Signal ØPC gesteuert wird. Nach dem Vorladen befindet sich die Fehlerleitung F aufgrund ihrer parasitären Kapazität $C_F$ in einem floatenden Zustand mit einem Potential gleich dem ersten logischen Pegel Pot.

Im ersten (B1) und im zweiten Block B2 werden jeweils eine der Wortleitungen, die zueinander korrespondieren, beispielsweise die in Fig. 2 mit "WL" bezeichneten Wortleitungen, ausgewählt und aktiviert. Dadurch werden die in den Speicherzellen SZ1 gespeicherten Daten auf die (im Beispiel erste) Bitleitungshälften (BL1 und BL2) der korrespondierenden Bitleitungen BL ausgelesen, durch die jeder der Bitleitungen BL zugeordnete (in Fig. 2 der Übersichtlichkeit wegen nicht dargestellt) Bewerterschaltungen BWS bewertet und vorverstärkt. Dies erfolgt parallel für alle Bitleitungen BL der Blöcke B1 und B2. Ist der Halbleiterspeicher in Ordnung, so befindet sich im konkreten Beispiel auf den ersten Bitleitungshälften BL1,BL2 als wahres Lesesignal ein Signal das dem ursprünglich eingespeicherten Datum entspricht. Auf den anderen (im konkreten Beispiel zweiten) Bitleitungshälften $\overline{BL1}$ , $\overline{BL2}$ bildet sich ein Signal aus, das zum wahren Lesesignal komplementär ist.

In dem Fall, in dem der Halbleiterspeicher in Ordnung ist, gilt also immer:
Signal auf BL1 = Signal auf BL2;
Signal auf $\overline{BL1}$ = Signal auf $\overline{BL2}$ ;
Signal auf BL1 (BL2): komplementär zu Signal auf $\overline{BL1}$ ( $\overline{BL2}$ ).

Mittels einer Komparatorschaltung COMP, die unweit der Fehlerleitung F angeordnet ist, und die damit im allgemeinen ebenfalls zwischen den beiden einander zugeordneten Blöcken B1,B2 liegt, werden die Signale auf den korrespondierenden Bitleitungen der beiden Blöcke B1,B2 miteinander verglichen. Dabei ist jedem Paar von korrespondierenden Bitleitungen BL zweier Blöcke B1,B2 eine Komparatorschaltung COMP zugeordnet, was der Übersichtlichkeit halber nicht dargestellt ist. Der Vergleich läuft so ab, daß die erste Bitleitungshälfte BL1 einer Bitleitung BL des ersten Blockes B1 mit der ersten Bitleitungshälfte BL2 der dazu korrespondierenden Bitleitung BL des zweiten Blockes B2 auf Übereinstimmung geprüft wird. Entsprechend wird die zweite Bitleitungshälfte $\overline{BL1}$ der gleichen Bitleitung BL des ersten Blockes B1 mit der zweiten Bitleitungshälfte $\overline{BL2}$ der korrespondierenden Bitleitung BL des zweiten Blockes B2 auf Übereinstimmung geprüft. Eine entsprechende Komparatorschaltung COMP ist insbesondere in Fig. 3 dargestellt. Sie wird noch erläutert.

Fällt mindestens eine der obengenannten Prüfungen auf Übereinstimmung negativ aus, so zieht die betroffene Komparatorschaltung COMP mit ihrem Ausgang die Fehlerleitung F in Richtung auf einen zweiten logischen Pegel, der zum ersten logischen Pegel Pot komplementär ist. Als zweiter logischer Pegel kann dabei auch das Bezugspotential VSS des Halbleiterspeichers verwendet werden. Anhand des Potentialverlaufes des Fehlersignales F läßt sich somit erkennen, ob ein Fehler vorliegt oder nicht. Da für jedes Paar korrespondierender Bitleitungen BL zweier Blöcke B1,B2 eine Komparatorschaltung COMP vorgesehen ist, läßt sich das erfindungsgemäße Verfahren zeitlich parallel für alle korrespondierenden Bitleitungen zweier Blöcke durchführen bei Aktivieren je einer der korrespondierenden Wortleitungen dieser Blöcke B1,B2. Dies bedeutet einen sehr großen Zeitgewinn, verglichen sowohl mit herkömmlichen Prüfmethoden als auch mit der bereits genannten Prüfmethode nach EP-A 0 186 040.

Ist ein Halbleiterspeicher in mehr als zwei Blöcke B eingeteilt, wie in Fig. 1 angedeutet, so ist es weiterhin vorteilhaft, das erfindungsgemäße Verfahren zeitparallel für alle Blöcke B durchzuführen. Dazu werden die Blöcke B in Paare von einander zugeordneten Blöcken B1,B2 eingeteilt. Zwischen jeweils zwei einander zugeordneten Blöcken B1,B2 sind die Komparatorschaltungen COMP angeordnet (zahlenmäßig gleich der Anzahl der Bitleitungen eines der Blöcke B1,B2). Ebenso ist zwischen jeweils zwei Blöcken B1,B2 eine Fehlerleitung F vorgesehen. Über eine Auswerteschaltung AS (beispielsweise ein einfaches NAND-Gatter wie in Fig. 1) kann das Auftreten eines Fehlers auf einer einzigen Fehlerleitung F bereits erkannt werden und als Fehlersignal FS weitergegeben werden. Dieses kann dann beispielsweise an einen Ausgang des Halbleiterspeichers gegeben werden. Letzteres ist u.a. bekannt aus der EP-A 0 186 040.

Im Falle von mehr als zwei Blöcken B1,B2 empfiehlt es sich nicht, alle Fehlerleitungen F zu einer einzigen Fehlerleitung zusammenzufassen. Es könnte dabei leicht geschehen, daß das fehlerhafte Signal am Komparatorausgang dann zu schwach ist, die Fehlerleitung F in Richtung des zweiten logischen Pegels zu ziehen, so daß der Fehler nicht mehr erkannt werden könnte.

Die Bitleitungen werden zu Zeiten, in denen keine Vergleiche durchgeführt werden, von den Komparatorschaltungen COMP elektrisch entkoppelt. Dabei ist es günstig, die Entkopplung mittels eines Taktsignals $\emptyset$ und durch dieses gesteuerte Transfertransistoren TT vorzunehmen, wie in den Fig. 2 und 3 gezeigt.

Fig. 2 zeigt eine Schaltungsanordnung mit zwei einander zugeordneten Blöcken B1,B2, mit vier Wortleitungen WL,WL+1, mit zwei Bitleitungen BL, einer Komparatorschaltung COMP, einer Fehlerleitung F samt zugehörigen Transistoren TL zum Vorladen der Fehlerleitung F und Transfertransistoren TT samt Taktsignal $\emptyset$.

Unter der Annahme, daß im Testfall die Wortleitungen WL der beiden Blöcke B1,B2 aktiviert sind, sind folgende Elemente der beiden Blöcke B1,B2 als korrespondierend zu bezeichnen: WL; BL (mit den Bitleitungshälften BL1 und BL2, nicht jedoch mit den Bitleitungshälften $\overline{BL1}$ und $\overline{BL2}$ ; SZ1 (nicht SZ2).

Auf den Bitleitungshälften BL1,BL2, $\overline{BL1}$ , $\overline{BL2}$ sind gemäß den all seits bekannten kombinatorischen Regeln folgende Datenkombinationen in der Praxis möglich:

| BL1 | BL2 | $\overline{BL1}$ | $\overline{BL2}$ | Fehler erkannt: | Fig.2,3 | Fig. 4,5 |
|---|---|---|---|---|---|---|
| 0 | 0 | 0 | 0 | ja | nein | nein |
| 0 | 0 | 0 | 1 | ja | ja | ja |
| 0 | 0 | 1 | 0 | ja | nein | ja |
| 0 | 0 | 1 | 1 | nein | - | - |
| 0 | 1 | 0 | 0 | ja | ja | ja |
| 0 | 1 | 0 | 1 | ja | ja | ja |
| 0 | 1 | 1 | 0 | ja | ja | ja |
| 0 | 1 | 1 | 1 | ja | ja | ja |
| 1 | 0 | 0 | 0 | ja | nein | ja |
| 1 | 0 | 0 | 1 | ja | ja | ja |
| 1 | 0 | 1 | 0 | ja | nein | ja |
| 1 | 0 | 1 | 1 | ja | nein | ja |
| 1 | 1 | 0 | 0 | nein | - | - |
| 1 | 1 | 0 | 1 | ja | ja | ja |
| 1 | 1 | 1 | 0 | ja | nein | ja |
| 1 | 1 | 1 | 1 | ja | nein | nein |

## Tabelle

Von diesen 16 Kombinationen sind zwei fehlerfrei, der Rest stellt einen Fehlerfall dar. Die Komparatorschaltungen nach Fig. 2 arbeitet nur teilweise wie das zuvor geschilderte erfindungsgemäße Verfahren: Fehler werden nur dann erkannt, wenn entweder auf der ersten Bitleitungshälfte BL2 der Bitleitung des zweiten Blockes B2 eine logische "1" anliegt (positive Logik sei angenommen) und auf der ersten Bitleitungshälfte BL1 der korrespondierenden Bitleitung BL des ersten Blockes B1 eine logische "0" anliegt oder bzw. und wenn auf der zweiten Bitleitungshälfte $\overline{BL2}$ der Bitleitung BL des zweiten Blockes B2 eine logische "1" anliegt und auf der zweiten Bitleitungshälfte $\overline{BL1}$ der korrespondierenden Bitleitung BL des ersten Blockes BL1 eine logische "0" anliegt.

Jede Komparatorschaltung COMP ist dazu so ausgelegt, daß ein Datum (Signal), aus auf der ersten Bitleitungshälfte BL1 (bzw.BL2) einer der beiden korrespondierenden Bitleitungen BL anliegt, über ein Schaltmittel T (vorteilhafterweise ein Transistor) auf die Fehlerleitung F durchschaltbar ist. Dazu wird das Schaltmittel T von einem Datum (Signal) gesteuert, das auf der ersten Bitleitungshälfte BL2 (bzw. BL1) der anderen der beiden korrespondierenden Bitleitungen BL anliegt. Entsprechend ist ein Datum (Signal), das auf der zweiten Bitleitungshälfte $\overline{BL1}$ (bzw. $\overline{BL2}$ ) der einen der beiden korrespondierenden Bitleitungen BL anliegt, über ein weiteres Schaltmittel WT (vorteilhafterweise ebenfalls ein Transistor) auf die Fehlerleitung F durchschaltbar. Dazu wird das weitere Schaltmittel WT von einem Datum (Signal) gesteuert, das auf der zweiten Bitleitungshälfte $\overline{BL2}$ (bzw. $\overline{BL1}$ ) der anderen der beiden korrespondierenden Bitleitungen BL anliegt. Jede Komparatorschaltung COMP nach Fig. 2 enthält also effektiv je zwei Schaltmittel T und WT, die vorteilhafterweise Transistoren sind. Damit wird bei minimalem Mehraufwand an Fläche und Schaltelementen ein paralleles Testen aller an einer Wortleitung liegenden Speicherzellen ermöglicht. Es wird bei dieser Ausführungsform jedoch in Kauf genommen, daß lediglich die Hälfte aller möglicherweise auftretenden Fehler erkannt wird. Zwischen jeder Komparatorschaltung COMP und den beiden ihr zugeordneten Bitleitungshälften BL1, $\overline{BL1}$ des ersten Blockes B1 liegt jeweils noch ein Transfertransistor TT samt zugehörigen (gemeinsamem) Taktsignal Ø.

In einer weiteren vorteilhaften Ausführungsform enthält jede Komparatorschaltung COMP zwei XNOR-Schaltungen XNOR. Dies ist in Fig. 3 dargestellt. Jede der XNOR-Schaltungen XNOR enthält zwei Schaltmittel T1,T2. Die Schaltmittel können vorteilhafterweise Transistoren sein. Die gesteuerten Ausgänge der Schaltmittel T1,T2 (im Falle von Transistoren üblicherweise mit Drain bezeichnet) der ersten XNOR-Schaltung XNOR sind gemeinsam mit der Fehlerleitung F verbunden. Das eine (T1) der beiden Schaltmittel ist eingangsmäßig (Source) über einen Transfertransistor TT mit der ersten Bitleitungshälfte BL1 der korrespondierenden Bitleitung BL des ersten Blockes B1 verbunden und steuerungsmäßig (Gate) ebenfalls über einen Transfertransistor TT mit der ersten Bitleitungshälfte BL2 der korrespondierenden Bitleitung BL des zweiten Blockes B2.

Das andere (T2) der beiden Schaltmittel der ersten XNOR-Schaltung XNOR ist eingangsmäßig (Source) ebenfalls über einen der Transfertransistoren TT mit der ersten Bitleitungshälfte BL2 der korrespondierenden Bitleitung BL des zweiten Blockes B2 verbunden und steuerungsmäßig (Gate) wiederum über einen der ·Transfertransistoren TT mit der ersten Bitleitungshälfte BL1 der korrespondierenden Bitleitung BL des ersten Blockes B1. Analoges gilt für die zweite XNOR-Schaltung XNOR, wobei als Bitleitungshälften die anderen Bitleitungshälften $\overline{BL1}$ und $\overline{BL2}$ der beiden Bitleitungen BL verwendet sind. Dies ist aus der Zeichnung ersichtlich. Die Transfertransitoren TT werden durch das Taktsignal Ø gesteuert.

Es ist weiterhin vorteilhaft, daß in dem Falle, in dem ein Halbleiterspeicher mehr als zwei Blöcke B aufweist, jeweils zwei Blöcke B eine der Anzahl der Bitleitungen BL eines Blockes B entsprechende bezw. gleiche Anzahl von Komparatorschaltungen COMP zugeordnet ist. Jede so entstandene Reihe von Komparatorschaltungen COMP enthält demgemäß eine Fehlerleitung F. Alle so entstehenden Fehlerleitungen F sind innerhalb des Halbleiterspeichers so zusammengeführt (siehe auch Fig. 1), daß eine Fehleranzeige auf einer einzigen Fehlerleitung F ausreicht, um insgesamt ein Fehlersigal FS zu setzen, das den Fehler anzeigt. Vorteilhafterweise erfolgt dies mittels einer beispielsweise als OR-, AND-,NOR-oder NAND-Schaltung ausgelegten Auswerteschaltung AS.

Bezüglich eines möglichen Parallelbetriebes von mehr als zwei Blöcken B eines Halbleiterspeichers in Verbindung mit der vorliegenden Erfindung wird auf die bereits genannte EP-A 0 186 040 verwiesen.

Das erfindungsgemäße Verfahren und insbesondere die Ausführungsform nach Fig. 3 vermögen 6/7 der lt. Tabelle möglichen Fehler zu erkennen, nicht jedoch die beiden Fälle, in denen auf allen Bitleitungshälften zweier korrespondierender Bitleitungen BL entweder nur "log. 0" oder nur "log. 1" als ausgelesene und bewertete Signale anliegen. Wegen der durch das erfindungsgemäße Verfahren und die erfindungsgemäße Schaltungsanordnung erzielbaren Vorteile (extrem kurze Testzeiten für beliebige, in den einander zugeordneten Blöcken übereinstimmende Prüfmuster gegenüber herkömmlichem Testbetrieb bei minimalem Schaltungsaufwand, insbesondere den notwendigen Flächenmehrbedarf betreffend) wird dieser Nachteil in Kauf genommen, noch dazu; wo zu erwarten ist, daß bei einem solch gravierenden Fehler auch noch bei anderen korrespondierenden Wortleitungen und/oder Bitleitungen Fehler auftreten, insbesondere von der Art, daß sie von der Erfindung erkannt werden.

Es ist vorteilhaft, das erfindungsgemäße Verfahren bei Bild-oder Textverarbeitung mittels Halbleiterspeichern (z.B. Video-RAM) zu verwenden.

Es ist weiterhin vorteilhaft, die erfindungsgemäße Schaltungsanordnung in einem Speicher für Bild-oder Textverarbeitung (z.B. Video-RAM) vorzusehen und diese Schaltungsanordnung dort im Normalbetrieb zu betreiben.

Hinsichtlich der Erzeugung von speziellen Test-und Steuersignalen wird insbesondere auf das im Zeitrang gleiche Schutzrecht mit dem anmelderinternen Aktenzeichen VPA 87 P 8013 hingewiesen. Bezüglich spezieller Dekoderausgestaltungen wird auf die im Zeitrang gleichen Schutzrechte mit den anmelderinternen Aktenzeichen VPA 87 P 8018, VPA 87 P 8020 hingewiesen.

## Ansprüche

1. Verfahren zum Prüfen eines Halbleiterspeichers
- dessen Speicherzellen (SZ) matrixförmig und in einer geradzahligen Anzahl von bezüglich der Speicherzellen (SZ) gleichen Blöcken (B) angeordnet sind,
- dessen Speicherzellen (SZ) in jedem Block (B) über Wortleitungen (WL) und Bitleitungen (BL) adressierbar sind,
- dessen Bitleitungen (BL) innerhalb jeden Blockes (B) in eine erste und eine zweite Bitleitungshälfte (BL1, $\overline{BL1}$ ; BL2, $\overline{BL2}$ ) eingeteilt sind, wobei beide Bitleitungshälften (BL1, $\overline{BL1}$ ; BL2, $\overline{BL2}$ ) mit einer Bewerterschaltung (BWS) verbunden sind,
- dessen Blöcke (B) jeweils paarweise als erster und zweiter Block (B1,B2) einander zugeordnet sind in der Art, daß unter jeder beliebigen blockinternen Adresse in den beiden Blöcken jeweils eine Speicherzelle (SZ1;SZ2) adressierbar ist, wobei die so adressierbaren Speicherzellen (SZ1;SZ2) als korrespondierende Adressen gelten, wobei die den korrespondierenden Speicherzellen (SZ1;SZ2) zugehörigen Bitleitungen (BL1,BL2; $\overline{BL1}$ , $\overline{BL2}$ ) als korrespondierende Bitleitungen gelten und wobei die den korrespondierenden

6

Speicherzellen (SZ1;SZ2) zugehörigen Wortleitungen (WL;WL + 1) als korrespondierende Wortleitungen gelten,

**gekennzeichnet durch** folgende Verfahrensschritte:

a) in die Speicherzellen (SZ) von wenigstens zwei einander zugeordneten Blöcken (B1,B2) werden Daten eingeschrieben in der Art, daß jeweils zwei korrespondierenden Speicherzellen (SZ1;SZ2) gleiche Daten enthalten,

b) eine Fehlerleitung (F) wird auf einen ersten logischen Pegel (Pot), insbesondere auf Versorgungspotential (VCC) des Halbleiterspeichers vorgeladen,

c) im ersten und im zweiten Block (B1,B2) werden jeweils eine der zueinander korrespondierenden Wortleitungen (WL;WL + 1) ausgewählt und aktiviert, wodurch sich auf den korrespondierenden Bitleitungen (BL) die ursprünglich eingeschriebenen Daten in ausgelesener, bewerteter und verstärkter Form als wahre und als dazu komplementäre Lesesignale ausbilden, falls der Halbleiterspeicher gut ist,

d) die wahren Lesesignale von jeweils zwei korrespondierenden Bitleitungen (BL) werden mittels einer Komparatorschaltung (COMP) miteinander verglichen und auf Übereinstimmung geprüft und die dazu komplementären Lesesignale der zwei korrespondierenden Bitleitungen (BL) werden ebenfalls mittels derselben Komparatorschaltung (COMP) miteinander verglichen und auf Übereinstimmung geprüft,

e) bei Erkennen eines Fehlers zieht die Komparatorschaltung (COMP) die Fehlerleitung (F) in Richtung auf einen zweiten logischen Pegel, der zum ersten logischen Pegel (Pot,VCC) komplementär ist, insbesondere in Richtung Bezugspotential (VSS) des Halbleiterspeichers.

2. Verfahren nach Anspruch 1, **dadurch gekennzeichnet,** daß es bei Vorhandensein von mehr als zwei Blöcken (B) bezüglich jedem der Blöcke zeitparallel durchgeführt wird, wobei das Vorliegen eines Fehlers an mindestens einer der Fehlerleitungen (F) als Fehler des gesamten Halbleiterspeichers gewertet wird.

3. Verfahren nach einem der Ansprüche 1 oder 2, **dadurch gekennzeichnet,** daß die Komparatorschaltungen (COMP) außerhalb des Vergleichszeitraumes von den Bitleitungen (BL) elektrisch entkoppelt werden.

4. Verfahren nach Anspruch 3, **dadurch gekennzeichnet,** daß die Entkopplung mittels eines Taktsignales (∅) und Transfertransistoren (TT) durchgeführt wird.

5. Schaltungsanordnung zum Prüfen eines Halbleiterspeichers

- dessen Speicherzellen (SZ) matrixförmig und in einer geradzahligen Anzahl von bezüglich der Speicherzellen (SZ) gleichen Blöcken (B) angeordnet sind,

- dessen Speicherzellen (SZ) in jedem Block (B) über Wortleitungen (WL) und Bitleitungen (BL) adressierbar sind,

- dessen Bitleitungen (BL) innerhalb jeden Blockes (B) in eine erste und eine zweite Bitleitungshälfte (BL1, $\overline{BL1}$ ; BL2, $\overline{BL2}$ ) eingeteilt sind, wobei beide Bitleitungshälften (BL1, $\overline{BL1}$ ; BL2, $\overline{BL2}$ ) mit einer Bewerterschaltung (BWS) verbunden sind,

- dessen Blöcke (B) jeweils paarweise als erster und zweiter Block (B1,B2) einander zugeordnet sind in der Art, daß unter jeder beliebigen blockinternen Adresse in den beiden Blöcken jeweils eine Speicherzelle (SZ1;SZ2) adressierbar ist, wobei die so adressierbaren Speicherzellen (SZ1;SZ2) als korrespondierende Adressen gelten, wobei die den korrespondierenden Speicherzellen (SZ1;SZ2) zugehörigen Bitleitungen (BL1,BL2; $\overline{BL1}$ , $\overline{BL2}$ ) als korrespondierende Bitleitungen gelten und wobei die den korrespondierenden Speicherzellen (SZ1;SZ2) zugehörigen Wortleitungen (WL;WL + 1) als korrespondierende Wortleitungen gelten,

**gekennzeichnet durch** folgende Merkmale:

a) Zwischen jeweils zwei korrespondierenden Bitleitungen (BL) der beiden Blöcke (B1,B2) ist eine Komparatorschaltung (COMP) angeordnet,

b) den beiden Blöcken (B1,B2) ist eine Fehlerleitung (F) zugeordnet, die mit allen zwischen den beiden Blöcken (B1,B2) liegenden Komparatorschaltungen (COMP) verbunden ist und die im Lesebetrieb vor dem Bewerten und Verstärken der aus den Speicherzellen (SZ) ausgelesenen Daten auf einen ersten logischen Pegel (Pot), vorzugsweise auf das Versorgungspotential (VCC) des Halbleiterspeichers vorgeladen ist,

c) in jeder Komparatorschaltung (COMP) ist das Datum, das auf der ersten Hälfte (BL1;BL2) der einen der beiden korrespondierenden Bitleitungen (BL) anliegt, über ein Schaltmittel (T), das von dem Datum gesteuert wird, das auf der ersten Hälfte (BL2;BL1) der anderen der beiden Bitleitungen (BL) anliegt, auf die Fehlerleitung (F) durchschaltbar,

d) in jeder Komparatorschaltung (COMP) ist des weiteren das Datum, das auf der zweiten Hälfte ( $\overline{BL1}$ ; $\overline{BL2}$ ) der einen der beiden korrespondierenden Bitleitungen (BL) anliegt, über ein weiteres Schaltmittel (WT), das von dem Datum gesteuert wird, das auf der zweiten Hälfte ( $\overline{BL2}$ ; $\overline{BL1}$ ) der anderen der beiden Bitleitungen (BL) anliegt, ebenfalls auf die Fehlerleitung (F) durchschaltbar,

e) bei jeder Komparatorschaltung (COMP) ist zwischen dieser und jeder Bitleitungshälfte (BL1, $\overline{BL1}$ ;BL2, $\overline{BL2}$ ) der korrespondierenden Bitleitungen (BL) der einander zugeordneten Blöcke (B1,B2) ein weiteres, von einem Taktsignal (∅) gesteuertes Schaltmittel (WT) angeordnet.

6. Schaltungsanordnung nach Anspruch 5, **dadurch gekennzeichnet**, daß die Komparatorschaltung (COMP) zwei XNOR-Schaltungen (XNOR) enthält.

7. Schaltungsanordnung nach Anspruch 6, **dadurch gekennzeichnet**, daß jede XNOR-Schaltung (XNOR) zwei Schaltmittel (T1,T2) enthält, deren gesteuerte Ausgänge gemeinsam mit der Fehlerleitung (F) verbunden sind, daß das eine (T1) der beiden Schaltmittel eingangsmäßig mit einer der Bitleitungshälften (BL1; $\overline{BL1}$ ) einer der Bitleitungen (BL) des ersten Blockes (B1) verbunden ist und steuerungsmäßig mit einer der Bitleitungshälften (BL2; $\overline{BL2}$ ) der korrespondierenden Bitleitung des zweiten Blockes (B2) verbunden ist und daß das andere (T2) der beiden Schaltmittel eingangsmäßig mit einer der Bitleitungshälften (BL2; $\overline{BL2}$ ) der korrespondierenden Bitleitung (BL) des zweiten Blockes (B2) verbunden ist und steuerungsmäßig ebenfalls mit einer der Bitleitungshälften (BL1; $\overline{BL1}$ ) der korrespondierenden Bitleitung (BL) des ersten Blockes (B1) verbunden ist.

8. Schaltungsanordnung nach einem der Ansprüche 5 bis 7, **dadurch gekennzeichnet**, daß die Schaltmittel (T1,T2) Transistoren sind.

9. Schaltungsanordnung nach einem der Ansprüche 5 bis 8, **dadurch gekennzeichnet**, daß bei mehr als zwei Blöcken (B) jeweils zwei Blöcken (B1,B2) eine der Anzahl der Bitleitungen (BL) entsprechende Anzahl von Komparatorschaltungen (COMP) sowie eine Fehlerleitung (F) zugeordnet sind und daß die so notwendigen mehreren Fehlerleitungen (F) so zusammengeführt sind, daß eine Fehleranzeige auf einer einzigen Fehlerleitung (F) ausreicht, um insgesamt ein Fehlersignal (FS) zu erzeugen und so einen Fehler anzuzeigen.

10. Schaltungsanordnung nach Anspruch 9, **dadurch gekennzeichnet**, daß die Zusammenführung als OR-, AND-, NOR-oder NAND-Schaltung ausgeführt ist.

11. Schaltungsanordnung nach einem der Ansprüche 5 bis 10, **dadurch gekennzeichnet**, daß sie in einem Speicher für Bild-oder Textverarbeitung verwendet ist zum schnellen Vergleichen des Dateninhalts zweier einander zugeordneter Blöcke (B1,B2) im Normalbetrieb.

12. Verfahren nach einem der Ansprüche 1 bis 4, **dadurch gekennzeichnet**, daß es für Bild-oder Textverarbeitung mittels Halbleiterspeicher verwendet wird.

# FIG 1

# FIG 2

# FIG 3

Europäisches
Patentamt

**EUROPÄISCHER RECHERCHENBERICHT**

Nummer der Anmeldung

EP 88 10 4111

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | IEEE TRANSACTIONS ON ELECTRON DEVICES, Band ED-32, Nr. 2, Februar 1985, Seiten 508-515, IEEE, New York, US; Y. YOU et al.: "A self-testing dynamic RAM chip" * Seite 508, rechte Spalte, Zeilen 17-20; Seite 511, rechte Spalte, Zeilen 26-28; Seite 514, linke Spalte, Zeile 58 - rechte Spalte, Zeile 10; Seite 514, rechte Spalte, Zeilen 33-37; Figur 11 * | 1,2 | G 11 C 29/00 |
| | --- | | |
| Y | DE-A-3 530 591 (MITSUBISHI) * Seite 16, Zeilen 16-19; Seite 26, Zeile 10 - Seite 29, Zeile 20 * | 1,2 | |
| | --- | | |
| A | IBM TECHNICAL DISCLOSURE BULLETIN, Band 27, Nr. 7B, Dezember 1984, Seiten 4534-4536, New York, US; R.C. CADY et al.: "RAM internal parallel testing technique" * Seite 4535, Zeilen 5-13; Seite 4536, Zeilen 10-19 * | 1 | |
| | | | **RECHERCHIERTE SACHGEBIETE (Int. Cl.4)** |
| | --- | | |
| A | US-A-4 044 340 (HITACHI) ----- | | G 11 C 29/00<br>G 06 F 11/26 |

Der vorliegende Recherchenbericht wurde für alle Patentansprüche erstellt

| Recherchenort | Abschlußdatum der Recherche | Prüfer |
|---|---|---|
| DEN HAAG | 08-06-1988 | HERREMAN,G.L.O. |

# SIEMENS

Europäisches Patentamt
Erhardtstraße 27

8000 München 2

EPA EPO OEB

0 6 -04- 1988

05

Ihre Zeichen und Ihre Nachricht vom
88104111.5

Unsere Zeichen
VPA 87 P 8015 E
Ke 1 EM

München, Franziskanerstraße 14
25. März 1988

Anmeldung Nr. 88104111.5

Nur

Zum Zwecke der Veröffentlichung,
Berichtigung(en)
☐ stattgegeben
☐ stattgegeben mit Ausnahme der gestrichenen Punkte
☐ nicht stattgegeben

Unterschrift:      Datum: 2 4. 04. 88

Eingangsstelle

Es wird Berichtigung nach Regel 88 AO EPÜ beantragt.

Zu den Berichtigungen im einzelnen:
- Seite 5, Zeile 4: "TR" ist ersetzt durch "Tr". Daß die Berichtigung so lauten muß und nicht anders lauten kann, geht aus den FIG 2 und 3 hervor.
- Seite 7, Zeile 27: "zugehörigen Transistoren TL" ist ersetzt durch "zugehörigem Transistor Tr". Daß die Berichtigung so lauten muß und nicht anders lauten kann, geht aus Seite 5, Zeilen 3 bis 5 (Schreibfehler in Zeile 4: "TR" anstelle von "Tr"; siehe oben) in Verbindung mit den FIG 2 und 3 hervor.
- Seite 11, Zeilen 29 bis 32: Es sind die der Anmelderin nunmehr bekannten amtlichen Aktenzeichen angegeben. Die Richtigkeit der

Adresse
Siemens AG
VPA PA B

Bearbeiter
Kempfle

Fernwahl 089
☏ 4158- 254
Vermittlung 4158-1

Fax 089
4158-397
Vermittlung 4158-1

52 100-45 sie d
Telegramme:
siemensdir
muenchen (vpa)

Postfach 220261, D-8000 München 22

Siemens Aktiengesellschaft Vertrags- und Patentabteilung      Leitung: Reinhard Ernst

Angaben ist den zugehörigen Anträgen auf Erteilung eines europäischen Patentes entnehmbar.

- Seite 15, Patentanspruch 5, letzte beiden Zeilen: Der Ausdruck
  "Schaltmittel (WT)" ist unter entsprechender grammatikalischer
  Anpassung ersetzt durch "Transfertransistor (TT)", wobei das
  Wort "weiteres" samt folgendem entfällt. Diese Berichtigung
  wird u.a. gestützt auf Seite 7, Zeilen 7 bis 28, die Patentansprüche 3 und 4 sowie auf die FIG 2 und 3.
- Blatt 2/2 der Zeichnung: Das Bezugszeichen "Ø" wurde nachgetragen, gestützt auf (unter anderem) Seite 7, Zeilen 20 bis 22
  und Zeile 28.

Siemens Aktiengesellschaft                Anlagen (3-fach)

i.V.

Löpertz
Allg. Vollmacht Nr. 650